# EUROPÄISCHE PATENTANMELDUNG

(11) **EP 2 578 948 A1**
(43) Veröffentlichungstag der Anmeldung: **10.04.2013**
(21) Anmeldenummer: 12185251.1
(22) Anmeldetag: 20.09.2012
(51) Int. Cl.: F24C 7/08, A47L 15/42, B60K 37/06, D06F 39/00, G05G 1/08, H03K 17/95

(54) **Hausgerätvorrichtung mit zumindest einer Trägereinheit und zumindest einer Befestigungseinheit zu einer seitlichen Befestigung**

(30) Priorität: 03.10.2011 ES 201131589
(71) Anmelder: BSH Bosch und Siemens Hausgeräte GmbH, 81739 München (DE)
(72) Erfinder: Arnal Valero, Adolfo, 50009 Zaragoza (ES); Mairal Serrano, Carlos Vicente, 50015 Zaragoza (ES); Martin Gomez, Damaso, 20012 Zaragoza (ES); Perez Cabeza, Pilar, 50008 Zaragoza (ES)

(57) **Zusammenfassung**

Die Erfindung geht aus von einer Hausgerätvorrichtung mit zumindest einer Bedienerschnittstelleneinheit (24), zumindest einem Bedienoberflächenelement (28) und mit zumindest einer Trägereinheit (10), die einen Basiskörper (12) aufweist und zu einem Halten zumindest eines Touch-Bedienelements (26) der Bedienerschnittstelleneinheit (24) an dem Bedienoberflächenelement (28) vorgesehen ist.

Um eine stabile Befestigung zu erreichen, wird zumindest eine Befestigungseinheit (14), die den Basiskörper (12) seitlich überragt und die zu einer seitlichen Befestigung der Trägereinheit (10) an einem Körper (32) vorgesehen ist, vorgeschlagen.

## Beschreibung

Die Erfindung geht aus von einer Hausgerätvorrichtung mit zumindest einer Bedienerschnittstelleneinheit, zumindest einem Bedienoberflächenelement und mit zumindest einer Trägereinheit, die zu einem Halten zumindest eines Touch-Bedienelements der Bedienerschnittstelleneinheit an dem Bedienoberflächenelement vorgesehen ist, nach dem Oberbegriff des Anspruchs 1.

Es sind bereits Hausgerätvorrichtungen mit zumindest einer Trägereinheit bekannt, die dazu vorgesehen ist, zumindest ein Touch-Bedienelement an einer Unterseite einer Bedienoberfläche zu halten.

Die Aufgabe der Erfindung besteht insbesondere darin, eine gattungsgemäße Vorrichtung mit einem geringen Platzbedarf zur Verfügung zu stellen. Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

Die Erfindung geht aus von einer Hausgerätvorrichtung mit zumindest einer Bedienerschnittstelleneinheit, zumindest einem Bedienoberflächenelement und mit zumindest einer Trägereinheit, die einen Basiskörper aufweist und die zu einem Halten zumindest eines Touch-Bedienelements der Bedienerschnittstelleneinheit an dem Bedienoberflächenelement vorgesehen ist.

Unter einer "Bedienerschnittstelleneinheit" soll insbesondere eine Einheit verstanden werden, welche zumindest eine Bedieneinheit aufweist und die vorteilhaft zumindest eine Anzeigeeinheit aufweist, wobei vorzugsweise die Bedieneinheit in die Anzeigeeinheit integriert ist. Unter einer "Bedieneinheit" soll insbesondere eine Einheit verstanden werden, über die eine Eingabe von Steuerungsbefehlen durch einen Bediener vorgesehen ist. Insbesondere kann die Bedieneinheit ein Bedienoberflächenelement umfassen. Unter einer "Anzeigeeinheit" soll insbesondere eine Einheit verstanden werden, welche dazu vorgesehen ist, einem Benutzer in einer visuellen Darstellung Daten, insbesondere Daten über Betriebskenngrößen eines Hausgeräts, anzuzeigen. Unter "Betriebskenngrößen" sollen insbesondere Kenngrößen des Hausgeräts verstanden werden, welche einen aktuellen Betriebszustand des Hausgeräts charakterisieren, beispielsweise eine erreichte Heiztemperatur bei einem als Gargerät ausgebildeten Hausgerät oder eine bestehende Kühltemperatur bei einem als Kühlschrank ausgebildeten Hausgerät. Vorzugsweise zeigt die Anzeigeeinheit insbesondere Betriebskenngrößen an, die durch über die Bedieneinheit eingegebene Steuerungsbefehle eingestellt werden können. Unter einem "Bedienoberflächenelement" soll insbesondere ein Element verstanden werden, das eine Bedienoberfläche aufweist. Unter einer "Bedienoberfläche" soll insbesondere eine Oberfläche verstanden werden, die dazu vorgesehen ist, mit Bedienelementen, insbesondere mit Touch-Bedienelementen, derart zusammenzuwirken, dass durch Berührungen der Bedienoberfläche zumindest während eines Betriebs des Hausgeräts Steuerungsbefehle zu einer Steuerung des Betriebs durch den Benutzer eingegeben werden können. Unter einer "Trägereinheit" soll insbesondere eine Einheit verstanden werden, die dazu vorgesehen ist, eine Gewichtskraft zumindest eines zu tragenden Elements aufzunehmen und/oder das zu tragende Element an einer festgelegten Position zu halten. Unter einem "Touch-Bedienelement" soll insbesondere ein unterhalb einer Bedienoberfläche angeordnetes, vorteilhaft an einer Unterseite des Bedienoberflächenelements fest angebrachtes Bedienelement verstanden werden, das dazu vorgesehen ist, von dem Benutzer durch eine Berührung der Bedienoberfläche bedient zu werden. Unter einem "Basiskörper" soll insbesondere ein Element der Trägereinheit verstanden werden, welches einen Großteil einer Fläche und insbesondere einer Masse der Trägereinheit umfasst und dazu vorgesehen ist, einen Großteil der Gewichtskraft des von der Trägereinheit zu tragenden Elements aufzunehmen und abzuleiten und somit eine stabile Lagerung des zu tragenden Elements zu erreichen.

Um eine sichere Befestigung der Trägereinheit zu erreichen, wird eine Befestigungseinheit, die den Basiskörper seitlich überragt und die zu einer seitlichen Befestigung der Trägereinheit an einem Körper vorgesehen ist, vorgeschlagen. Darunter, dass die Befestigungseinheit den Basiskörper "seitlich überragt", soll insbesondere verstanden werden, dass die Befestigungseinheit an einer Seite des Basiskörpers angeordnet ist, die eine Hauptfläche des Basiskörpers begrenzt, dass eine maximale Erstreckung der Befestigungseinheit in eine zu einer Normalenrichtung der Hauptfläche senkrechte und von der Hauptfläche wegweisende Richtung verläuft und dass die maximale Erstreckung der Befestigungseinheit größer ist als eine Erstreckung anderer Elemente, die an der Seite des Basiskörpers angeordnet sind, in die zu der Normalenrichtung der Hauptfläche senkrechte Richtung. Unter einer "Hauptfläche" des Basiskörpers soll insbesondere eine Fläche des Basiskörpers mit einem maximalen Flächeninhalt verstanden werden. Unter einer "seitlichen Befestigung" soll insbesondere eine Befestigung verstanden werden, die an Stellen erfolgt, die mit dem Basiskörper nur über von der Normalenrichtung der Hauptfläche abweichende Geraden verbunden werden können. Unter einem "Körper" soll insbesondere eine zu einer Befestigung der Befestigungseinheit vorgesehene Ausformung eines Bauteils, insbesondere eines Gehäuses, eines Hausgeräts verstanden werden. Durch die seitliche Befestigung kann insbesondere ein geringer Platzbedarf der Trägereinheit unterhalb des Bedienoberflächenelements erreicht werden, da insbesondere eine geringe Ausdehnung der Trägereinheit durch Verzicht auf senkrecht zu der parallel zu der Bedienoberfläche liegenden Fläche des Basiskörpers verlaufende Befestigungselemente erreicht werden kann.

Ferner wird eine Spannkrafteinheit vorgeschlagen, die dazu vorgesehen ist, eine Spannkraft zu erzeugen, die die Bedienerschnittstelleneinheit an das Bedienoberflächenelement anpresst. Die Spannkrafteinheit weist vorzugsweise zumindest ein Element auf, das zu einer elastischen Verformung vorgesehen ist und das die Spannkraft mittels einer durch die elastische Verformung bewirkten Rückstellkraft erzeugt. Die Spannkrafteinheit kann beispielsweise als Spiralfeder ausgebildet sein, die die Spannkraft durch die elastische Verformung erzeugt. Durch die Spannkraft, die von der Spannkrafteinheit erzeugt wird, kann insbesondere eine spielfreie und feste Halterung eines Touch-Bedienelements der Bedienerschnittstelleneinheit an einer Unterseite des Bedienoberflächenelements erreicht werden, wodurch sichergestellt werden kann, dass durch die Berührung der Bedienoberfläche das Touch-Bedienelement bedient werden kann. Insbesondere kann dadurch, dass die Spannkraft die Bedienerschnittstelleneinheit an das Bedienoberflächenelement anpresst, ein Ausgleich von unterschiedlichem Spiel von Bereichen der Bedienerschnittstelleneinheit erreicht werden.

Ferner wird vorgeschlagen, dass die Spannkrafteinheit und die Befestigungseinheit zumindest teilweise einstückig miteinander ausgeführt sind. Unter "teilweise einstückig miteinander ausgeführt" soll insbesondere verstanden werden, dass zumindest ein Element der Befestigungseinheit mit einem Element der Spannkrafteinheit zumindest stoffschlüssig verbunden und vorteilhaft in einem Stück an das Element der Spannkrafteinheit angeformt ist und/oder vorzugsweise gemeinsam mit diesem in einem Stück hergestellt ist, beispielsweise durch eine Herstellung aus einem Guss und/oder durch eine Herstellung in einem Ein- oder Mehrkomponentenspritzverfahren und vorteilhaft aus einem einzelnen, gemeinsamen Rohling. Insbesondere kann die Spannkrafteinheit von der Befestigungseinheit gebildet sein. Es kann somit vorteilhaft eine hohe Stabilität der Spannkrafteinheit und eine sichere Einleitung der Spannkraft in die Trägereinheit erreicht werden sowie eine Anzahl an unterschiedlichen Elementen reduziert werden.

Ferner wird vorgeschlagen, dass die Befestigungseinheit zu einer formschlüssigen Befestigung der Trägereinheit an dem Körper vorgesehen ist. Insbesondere befinden sich Befestigungseinheit und Körper in einem geometrischen Eingriff ineinander. Es kann durch die formschlüssige Befestigung insbesondere eine feste Befestigung mit einfacher Konstruktion erreicht werden.

Ferner wird vorgeschlagen, dass die Befestigungseinheit zumindest ein Befestigungsmittel aufweist, das einen Schlitz aufweist. Insbesondere erfolgt die formschlüssige Befestigung der Befestigungseinheit dadurch, dass zumindest ein Element des Körpers sich in geometrischem Eingriff mit dem Schlitz befindet. Es kann somit insbesondere eine Befestigungseinheit zu einer formschlüssigen Befestigung erreicht werden, die eine einfache Konstruktion aufweist.

Ferner wird vorgeschlagen, dass die Befestigungseinheit zumindest ein Befestigungselement aufweist, das einstückig mit zumindest dem Basiskörper der Trägereinheit ausgebildet ist. Unter "einstückig" soll insbesondere verstanden werden, dass das Befestigungselement der Befestigungseinheit mit zumindest dem Basiskörper zumindest stoffschlüssig verbunden, vorteilhaft in einem Stück an den Basiskörper angeformt ist und/oder vorzugsweise gemeinsam mit diesem in einem Stück hergestellt ist, beispielsweise durch eine Herstellung aus einem Guss und/oder durch eine Herstellung in einem Ein- oder Mehrkomponentenspritzverfahren und vorteilhaft aus einem einzelnen, gemeinsamen Rohling. Es kann somit insbesondere eine Befestigungseinheit mit hoher Stabilität erreicht werden.

Ferner wird vorgeschlagen, dass die Trägereinheit zumindest einen gitterförmigen Basiskörper umfasst. Unter "gitterförmig" soll insbesondere verstanden werden, dass eine Hauptfläche des Basiskörpers, welche eine Fläche des Basiskörpers mit maximalem Flächeninhalt darstellt, materialfreie Bereiche aufweist, die zusammengenommen zumindest fünfzig Prozent, vorteilhaft zumindest siebzig Prozent und vorzugsweise zumindest neunzig Prozent der Fläche bilden. Es kann somit insbesondere ein stabiler und gewichtssparender Basiskörper erreicht werden.

Ferner wird vorgeschlagen, dass die Trägereinheit zumindest ein Abstandsmittel aufweist, das dazu vorgesehen ist, zumindest einen Teil der Bedienerschnittstelleneinheit von dem Basiskörper der Trägereinheit zu beabstanden. Insbesondere ist das Abstandsmittel als stabförmiges Abstandsmittel ausgebildet, welches einstückig mit dem Basiskörper ausgeführt ist. Es kann somit insbesondere eine sichere Halterung der Bedienerschnittstelleneinheit, insbesondere des Touch-Bedienelements der Bedienerschnittstelleneinheit, in einem vorgegebenen Abstand zu dem Bedienoberflächenelement erreicht werden.

Ferner wird vorgeschlagen, dass die Trägereinheit zumindest ein Arretiermittel aufweist, das dazu vorgesehen ist, zumindest eine Elektroleitung zu fixieren. Unter einem "Arretiermittel" soll insbesondere ein Mittel verstanden werden, das dazu vorgesehen ist, eine Bewegung der Elektroleitung in zumindest einer Raumrichtung, vorteilhaft in zumindest zwei Raumrichtungen, auf maximal eine dreifache, vorteilhaft maximal eine doppelte und vorzugsweise maximal eine anderthalbfache Länge eines Durchmessers der Elektroleitung in der entsprechenden Raumrichtung zu begrenzen. Unter einer "Elektroleitung" soll insbesondere ein Element verstanden werden, welches dazu vorgesehen ist, Strom zu einer Energieversorgung stromverbrauchender Elemente zu übertragen. Insbesondere ist die Elektroleitung von einem Stromkabel gebildet. Es kann somit insbesondere vorteilhaft eine sichere Halterung der Elektroleitung an dem Trägerelement und eine sichere Energieversorgung der Bedienerschnittstelleneinheit erreicht werden.

Ferner wird vorgeschlagen, dass das Bedienoberflächenelement als eine Kochfeldplatte ausgebildet ist. Insbesondere besteht die Kochfeldplatte zumindest teilweise aus einer Glaskeramik, die vorteilhaft aus einem Borosilikatglas oder einem anderen hitzebeständigen Glaswerkstoff hergestellt ist. Grundsätzlich kann die Kochfeldplatte aus anderen Materialien hergestellt sein, beispielsweise aus einem Verbundmaterial, das vorteilhaft einstückig mit dem zumindest einen Befestigungselement ausgebildet ist. Es kann somit insbesondere eine vorteilhafte Funktionsintegration der Bedienerschnittstelleneinheit in ein als Gargerät ausgebildetes Hausgerät erreicht werden.

Ferner wird ein Hausgerät, insbesondere ein Induktionskochfeld, mit einer erfindungsgemäßen Hausgerätvorrichtung vorgeschlagen. Das Hausgerät kann alternativ beispielsweise als Mikrowellenofen oder als Kühlschrank ausgebildet sein, wobei die Trägereinheit aus Sicht des Benutzers hinter einem senkrecht zu einem Boden, auf dem das Hausgerät abgestützt ist, verlaufenden Bedienoberflächenelement anstatt unterhalb eines parallel zu dem Boden verlaufenden Bedienoberflächenelements angeordnet sein kann.

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein als Induktionskochfeld ausgebildetes Hausgerät mit einer Hausgerätvorrichtung,
- Fig. 2: die Hausgerätvorrichtung mit einer Trägereinheit, die mit einer Befestigungseinheit seitlich an einem Körper eines Gehäuses eines Hausgeräts befestigt ist, und
- Fig. 3: die Trägereinheit mit der Befestigungseinheit, die einen Basiskörper seitlich überragt.

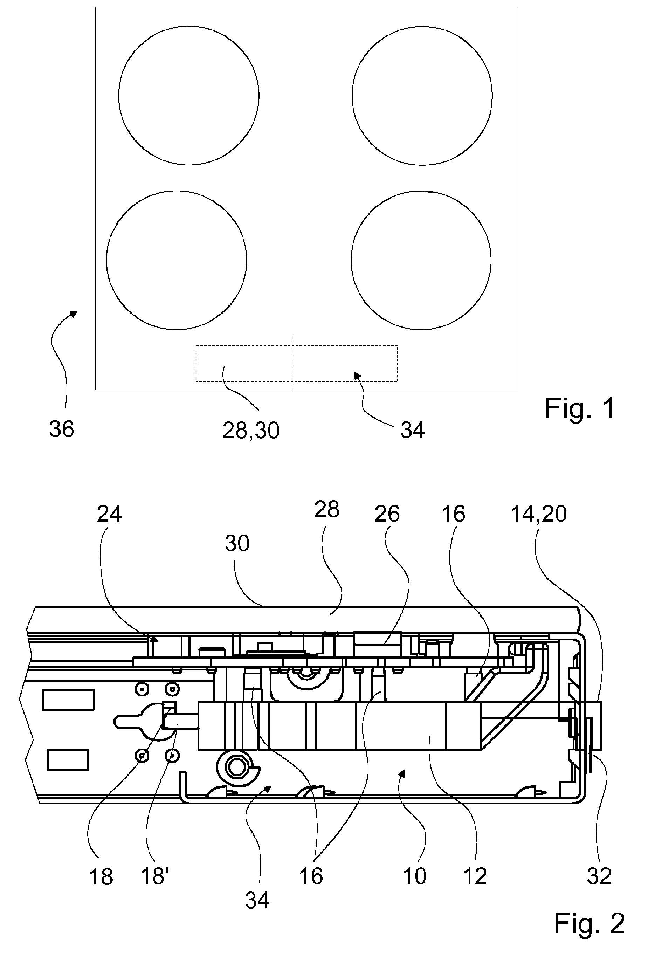

Fig. 1 zeigt schematisch ein als Induktionskochfeld ausgebildetes Hausgerät 36 mit einer Hausgerätvorrichtung 34. Das Hausgerät 36 weist ein als Kochfeldplatte ausgebildetes Bedienoberflächenelement 28 mit einer Bedienoberfläche 30 auf, wobei unterhalb der Bedienoberfläche 30 die Hausgerätvorrichtung 34 angeordnet ist. Die Hausgerätvorrichtung 34 wird in einem Schnittbild (Fig. 2) genauer dargestellt.

Die Hausgerätvorrichtung 34 umfasst eine Bedienerschnittstelleneinheit 24, die ein Touch-Bedienelement 26 sowie eine Trägerplatine und nicht dargestellte Anzeigeelemente umfasst, und eine Trägereinheit 10 mit einem Basiskörper 12, die zu einem Halten des Touch-Bedienelements 26 der Bedienerschnittstelleneinheit 24 an dem Bedienoberflächenelement 28 vorgesehen ist. Die Trägereinheit 10 weist zwei Befestigungseinheiten 14 auf, die den Basiskörper 12 an einem Körper 32, der eine Ausformung eines Gehäuses des Hausgeräts 36 darstellt, befestigen. Die Befestigungseinheiten 14 sind aus einem elastischen Kunststoff gefertigt und elastisch verformbar, wodurch sie eine Spannkraft erzeugen können.

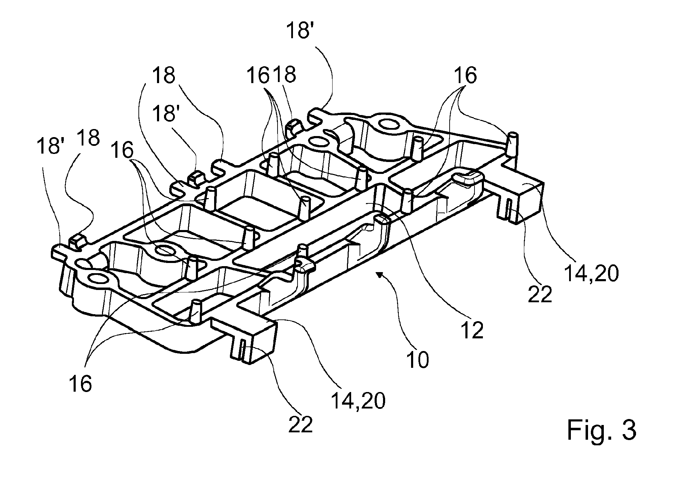

Fig. 3 zeigt die Trägereinheit 10 der Hausgerätvorrichtung 34 in einer detaillierten Darstellung. Der Basiskörper 12 der Trägereinheit 10 weist eine trapezförmige Grundform mit zwei zueinander parallelen, langen Seiten auf. An einer der zueinander parallelen, langen Seiten, die eine Hauptfläche des Basiskörpers 12 begrenzen, sind zwei seitlich den Basiskörper 12 überragende Befestigungseinheiten 14 angeordnet, die einstückig mit dem Basiskörper 12 ausgeführt sind. Die Befestigungseinheiten 14 befestigen die Trägereinheit 10 mit einer formschlüssigen Befestigung an dem Körper 32 und weisen ein Befestigungsmittel 22 auf, das einen Schlitz aufweist. Das Befestigungsmittel 22 befindet sich mit dem Schlitz in einem geometrischen Eingriff mit dem entsprechend ausgebildeten Körper 32 und bildet somit eine formschlüssige Befestigung der Trägereinheit 10 an dem Körper 32. Die Hauptfläche des Basiskörpers 12 bildet einen Winkel von hundertfünf Grad mit einer Erstreckungsrichtung des Schlitzes. In einem montierten Zustand der Hausgerätvorrichtung 34 (Fig. 2) tritt durch eine entsprechende Ausrichtung des Körpers 32 eine elastische Verformung der Befestigungseinheiten 14 ein, wodurch die Hauptfläche des Basiskörpers 12 einen rechten Winkel mit der Erstreckungsrichtung des Schlitzes einschließt und durch eine Rückstellkraft der elastischen Verformung eine Spannkraft erzeugt wird. Die Spannkraft bewirkt eine auf die Trägereinheit 10 wirkende Kraft, die die Trägereinheit 10 an das Bedienoberflächenelement 28 drückt. Die Befestigungseinheiten 14 wirken somit als Spannkrafteinheiten 20, die die Bedienerschnittstelleneinheit 24, die von der Trägereinheit 10 gelagert wird, an das Bedienoberflächenelement 28 anpresst. Die Spannkrafteinheiten 20 und die Befestigungseinheiten 14 sind somit einstückig miteinander ausgeführt.

Der Basiskörper 12 der Trägereinheit 10 ist als ein gitterförmiger Basiskörper 12 ausgeführt und weist an einer Hauptfläche, die eine Fläche des Basiskörpers 12 mit dem größten Flächeninhalt darstellt, Aussparungen auf, welche insgesamt siebzig Prozent einer Fläche der Hauptfläche ausmachen. Der gitterförmige Basiskörper 12 umfasst drei parallele Hauptstege, die durch vier schräg zu den Hauptstegen verlaufende und alle drei Hauptstege berührende Stege miteinander verbunden sind. Zwei weitere, in einem rechten Winkel zu den Hauptstegen verlaufende Stege verbinden zwei der Hauptstege zusätzlich miteinander. An dem Basiskörper 12 ist eine Vielzahl von Abstandsmitteln 16 und Arretiermitteln 18, 18' angeordnet. Sowohl der gitterförmige Basiskörper 12 als auch die Abstandsmittel 16 und die Arretiermittel 18,18' sind aus einem temperaturbeständigen Kunststoff gefertigt. Die Abstandsmittel 16 sind als stabförmige, einstückig mit dem Basiskörper 12 ausgeführte Elemente des Basiskörpers 12 ausgebildet, die an der Hauptfläche des Basiskörpers 12 in einer Höhe von 2 cm überstehen und die Bedienerschnittstelleneinheit 24 von dem Basiskörper 12 in der entsprechenden Höhe beabstanden. Das Touch-Bedienelement 26 wird durch die Beabstandung der Bedienerschnittstelleneinheit 24 von dem Basiskörper 12 in einer festen Position an einer Unterseite des Bedienoberflächenelements 28 gehalten, wodurch sichergestellt werden kann, dass durch eine Berührung einer Bedienoberfläche 30 des Bedienoberflächenelements 28 das Touch-Bedienelement 26 bedient werden kann. Die Arretiermittel 18 sind als halboffene, längliche Elemente ausgeführt, die einstückig mit der Trägereinheit 10 ausgebildet sind und die jeweils eine rillenförmige Vertiefung aufweisen, die in eine Richtung parallel zu einer Richtung einer größten Erstreckung des Basiskörpers 12 verläuft. Die rillenförmige Vertiefung weist eine Öffnungsrichtung in einer Richtung, in der sich die Abstandsmittel 16 erstrecken, auf. Arretiermittel 18 sind in Gruppen zu zwei oder drei Arretiermitteln 18 alternierend mit stabförmig ausgeführten Arretiermitteln 18' angeordnet. Die Gruppen der Arretiermittel 18, 18' sind auf einer den Befestigungseinheiten 14 abgewandten Seite des Basiskörpers 12 angeordnet. Die Arretiermittel 18, 18' dienen zu einer Lagerung einer als Stromkabel ausgeführten Elektroleitung, wobei die Lagerung durch die die rillenförmigen Vertiefungen bildenden Wandungen der Arretiermittel 18 erfolgt. Durch die Arretiermittel 18' wird die gelagerte Elektroleitung dergestalt in einer Position fixiert, dass eine Bewegung des Stromkabels in den Raumrichtungen senkrecht zu der größten Erstreckung des Basiskörpers 12 auf einen Durchmesser der rillenförmigen Vertiefungen begrenzt ist und somit eine Unterbrechung einer Stromversorgung durch eine Verschiebung des Stromkabels vermieden wird. In alternativen Ausgestaltungen der Arretiermittel kann eine Lagerung des Stromkabels beispielsweise durch ringförmig ausgeführte Elemente erfolgen, durch die das Stromkabel durchgeführt wird.

Die Trägereinheit 10 hält das Touch-Bedienelement 26 an der Unterseite des Bedienoberflächenelements 28 in direktem Kontakt mit dem Bedienoberflächenelement 28, wodurch sichergestellt ist, dass durch eine Berührung der Bedienoberfläche 30 durch einen Benutzer eine Steuerungseingabe vorgenommen werden kann. Das Touch-Bedienelement 26 ist als kapazitives Element ausgeführt, welches bei einer Annäherung eines Körperteils des Benutzers bei der Berührung der Bedienoberfläche 30 eine Änderung seiner Leitfähigkeit erfährt, wodurch ein Stromsignal ausgesandt wird. Durch die Berührung der Bedienoberfläche 30 durch den Benutzer wird über das ausgesandte Stromsignal somit eine Steuerungseingabe vorgenommen.

### Bezugszeichen

- 10: Trägereinheit
- 12: Basiskörper
- 14: Befestigungseinheit
- 16: Abstandsmittel
- 18: Arretiermittel
- 18': Arretiermittel
- 20: Spannkrafteinheit
- 22: Befestigungsmittel
- 24: Bedienerschnittstelleneinheit
- 26: Touch-Bedienelement
- 28: Bedienoberflächenelement
- 30: Bedienoberfläche
- 32: Körper
- 34: Hausgerätvorrichtung
- 36: Hausgerät

## Patentansprüche

1. Hausgerätvorrichtung mit zumindest einer Bedienerschnittstelleneinheit (24), zumindest einem Bedienoberflächenelement (28) und mit zumindest einer Trägereinheit (10), die einen Basiskörper (12) aufweist und die zu einem Halten zumindest eines Touch-Bedienelements (26) der Bedienerschnittstelleneinheit (24) an dem Bedienoberflächenelement (28) vorgesehen ist, **gekennzeichnet durch** zumindest eine Befestigungseinheit (14), die den Basiskörper (12) seitlich überragt und die zu einer seitlichen Befestigung der Trägereinheit (10) an einem Körper (32) vorgesehen ist.

2. Hausgerätvorrichtung nach Anspruch 1, **gekennzeichnet durch** zumindest eine Spannkrafteinheit (20), die dazu vorgesehen ist, eine Spannkraft zu erzeugen, die die Bedienerschnittstelleneinheit (24) an das Bedienoberflächenelement (28) anpresst.

3. Hausgerätvorrichtung nach Anspruch 2, **dadurch gekennzeichnet, dass** die Spannkrafteinheit (20) und die Befestigungseinheit (14) zumindest teilweise einstückig miteinander ausgeführt sind.

4. Hausgerätvorrichtung nach einem der vorhergehenden Ansprüche, **dadurch gekennzeichnet, dass** die Befestigungseinheit (14) zu einer formschlüssigen Befestigung der Trägereinheit (10) an dem Körper (32) vorgesehen ist.

5. Hausgerätvorrichtung nach Anspruch 4, **dadurch gekennzeichnet, dass** die Befestigungseinheit (14) zumindest ein Befestigungsmittel (22) aufweist, das einen Schlitz aufweist.

6. Hausgerätvorrichtung nach einem der vorhergehenden Ansprüche, **dadurch gekennzeichnet, dass** die Befestigungseinheit (14) zumindest ein Befestigungselement aufweist, das einstückig mit zumindest dem Basiskörper (12) der Trägereinheit (10) ausgeführt ist.

7. Hausgerätvorrichtung nach einem der vorhergehenden Ansprüche, **dadurch gekennzeichnet, dass** die Trägereinheit (10) zumindest einen gitterförmigen Basiskörper (12) umfasst.

8. Hausgerätvorrichtung nach einem der vorhergehenden Ansprüche, **dadurch gekennzeichnet, dass** die Trägereinheit (10) zumindest ein Abstandsmittel (16) aufweist, das dazu vorgesehen ist, zumindest einen Teil der Bedienerschnittstelleneinheit (24) von dem Basiskörper (12) der Trägereinheit (10) zu beabstanden.

9. Hausgerätvorrichtung nach einem der vorhergehenden Ansprüche, **dadurch gekennzeichnet, dass** die Trägereinheit (10) zumindest ein Arretiermittel (18) aufweist, das dazu vorgesehen ist, zumindest eine Elektroleitung zu fixieren.

10. Hausgerätvorrichtung nach einem der vorhergehenden Ansprüche, **dadurch gekennzeichnet, dass** das Bedienoberflächenelement (28) als eine Kochfeldplatte ausgebildet ist.

11. Trägereinheit einer Hausgerätvorrichtung 34 nach einem der vorhergehenden Ansprüche.

12. Hausgerät, insbesondere Induktionskochfeld, mit einer Hausgerätvorrichtung nach einem der vorhergehenden Ansprüche.
